# EUROPEAN PATENT APPLICATION

(11) **EP 4 659 835 A1**
(43) Date of publication of application: **10.12.2025**
(21) Application number: 25175248.1
(22) Date of filing: 09.05.2025
(51) Int. Cl.: B01D 45/16, B01D 45/18, B01F 23/00, B04C 5/00

(54) **DUST COLLECTING DEVICE**

(30) Priority: 23.05.2024 TW 113119038
(71) Applicant: Rayzher Industrial Co., Ltd., Zhubei City, Hsinchu 302054 (TW)
(72) Inventor: CHOU, Ku-Hua, 302054 Zhubei City, Hsinchu County (TW)
(74) Representative: Prinz & Partner mbB

(57) **Abstract**

A dust collecting device (Z) is provided. The dust collecting device (Z) includes a particle separation component (1), an airflow output component (2) and a particle collection component (3). One side of the particle separation component (1) extends outward to form a first gas input portion (11), one end of the particle separation component (1) extends outward to form a first gas output portion (12), and another end of the particle separation component (1) extends outward to form a foreign matter outlet portion (13). One side of the airflow output component (2) extends outward to form an airflow inlet portion (21), one end of the airflow output component (2) extends outward to form a second gas output portion (22), and another end of the airflow output component (2) extends outward to form a second gas input portion (23). The second gas output portion (22) is connected to the first gas input portion (11). The particle collection component (3) is connected to the foreign matter outlet portion (13).

## Description

### FIELD OF THE INVENTION

The present invention relates to a dust collecting device, and more particularly to a dust collecting device that has no consumption of electrical energy and water and can capture harmful substances.

### BACKGROUND OF THE INVENTION

As far as particle dust waste treatment systems in high-tech manufacturing industries are concerned, a fine dust collection device is required in many waste gas reduction processes. The fine dust in the exhaust gas is extremely fine solid particles that remain suspended in the air for a long time. Particles with a diameter of more than 10 microns are classified as coarse particles, and these particles will be adsorbed by nasal hairs or mucous membranes in the nasopharyngeal cavity. Fine dust with a diameter less than 10 microns (PM10) is a suspended particle. Once the suspended particles are inhaled into the human body, they will penetrate deep into the lungs along the trachea and bronchi.

Currently, in semiconductor manufacturing equipment, the wet scrubbing equipment (local scrubber) is used to filter out fine dust. However, the wet scrubbing equipment not only consumes energy (requires power supply and water supply), but also has many internal components and a complex structure, so that maintenance costs are considerable.

### SUMMARY OF THE INVENTION

In response to the above-referenced technical inadequacy, the present invention provides a dust collecting device.

In order to solve the above-mentioned problems, one of the technical aspects adopted by the present invention is to provide a dust collecting device, which includes at least one particle separation component, at least one airflow output component and at least one particle collection component. The at least one particle separation component has a main body, one side of the main body of the at least one particle separation component extends outward to form a first gas input portion, one end of the main body of the at least one particle separation component extends outward to form a first gas output portion, another end of the main body of the at least one particle separation component extends outward to form a foreign matter outlet portion, the first gas output portion is connected to a first external device, and the first gas input portion, the first gas output portion and the foreign matter outlet portion communicate with each other. The at least one airflow output component has a main body, one side of the main body of the at least one airflow output component extends outward to form an airflow inlet portion, one end of the main body of the at least one airflow output component extends outward to form a second gas output portion, another end of the main body of the at least one airflow output component extends outward to form a second gas input portion, the airflow inlet portion is connected to an external gas source device, the second gas output portion is connected to the first gas input portion, the second gas input portion is connected to a second external device, and the airflow inlet portion, the second gas output portion and the second gas input portion communicate with each other. The at least one particle collection component is connected to the foreign matter outlet portion.

One of the beneficial effects of the present invention is that the dust collection device provided by the present invention can improve the removal efficiency of the harmful substances and reduce production costs through the above technical solution.

These and other aspects of the present invention will become apparent from the following description of the embodiment taken in conjunction with the following drawings and their captions, although variations and modifications therein can be affected without departing from the spirit and scope of the novel concepts of the invention.

### BRIEF DESCRIPTION OF THE DRAWINGS

The described embodiments can be better understood by reference to the following description and the accompanying drawings, in which:
FIG. 1 is a schematic view of a dust collecting device in use state according to a first embodiment of the present invention;
FIG. 2 is a schematic exploded view of the dust collecting device according to the first embodiment of the present invention;
FIG. 3 is a schematic structural view of a particle separation component of the dust collecting device according to the first embodiment of the present invention;
FIG. 4 is a schematic top view of the particle separation component of the dust collecting device according to the first embodiment of the present invention;
FIG. 5 is a schematic cross-sectional view of an airflow output component of the dust collecting device according to the first embodiment of the present invention;
FIG. 6 is a schematic enlarged view of part VI of FIG. 5;
FIG. 7 is a schematic view of the particle separation component of the dust collecting device in use state according to the first embodiment of the present invention;
FIG. 8 is a schematic structural view of the dust collecting device according to a second embodiment of the present invention;
FIG. 9 is a schematic structural view of the dust collecting device according to a third embodiment of the present invention; and
FIG. 10 is a schematic structural view of the dust collecting device according to a fourth embodiment of the present invention.

### DETAILED DESCRIPTION OF THE EXEMPLARY EMBODIMENTS

The present invention is more particularly described in the following embodiments and examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [First Embodiment]

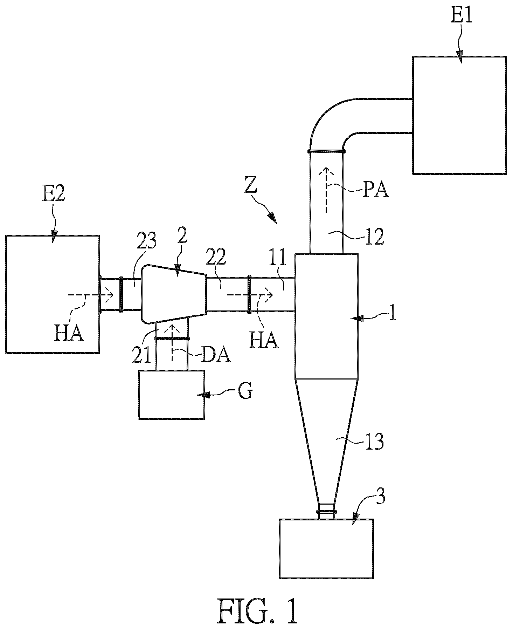

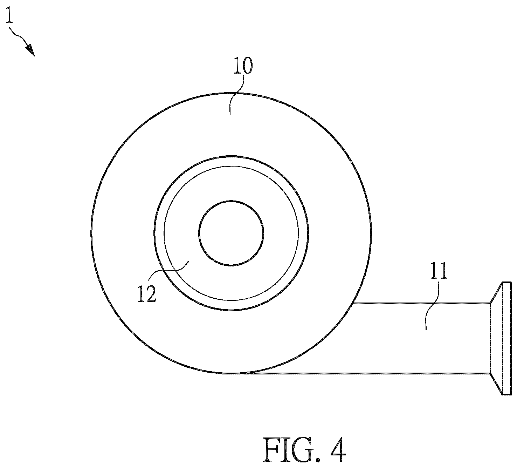

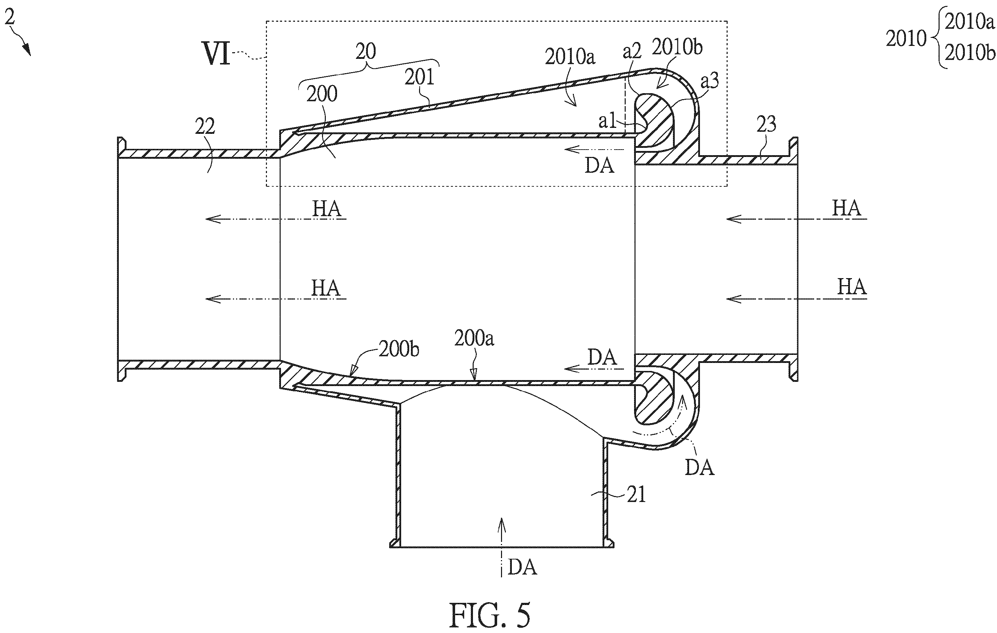

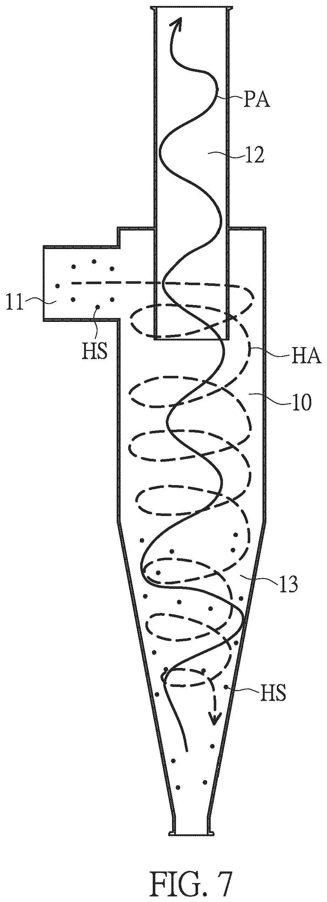

Please refer to FIG. 1 to FIG. 7, which show a schematic view of a dust collecting device in use state, a schematic exploded view of the dust collecting device, a schematic structural view of a particle separation component of the dust collecting device, a schematic top view of the particle separation component, a schematic cross-sectional view of an airflow output component of the dust collecting device, a schematic enlarged view of part VI of FIG. 5, and a schematic view of the particle separation component in use state respectively, according to the first embodiment of the present invention. As shown in the above figures, the first embodiment of the present invention provides a dust collecting device Z (or a dust collection device, or a dust collector), which includes at least one particle separation component 1 (or at least one particle separating component), at least one airflow output component 2 (or at least one airflow exhaust component), and at least one particle collection component 3 (or at least one particle collecting component).

As shown in FIG. 1 to FIG. 4 and FIG. 6, the particle separation component 1 can have a main body 10, and one side of the main body 10 of the particle separation component 1 can extend outward to form a first gas input portion 11. One end of the main body 10 of the particle separation component 1 can extend outward to form a first gas output portion 12, and another end of the main body 10 of the particle separation component 1 can extend outward to form a foreign matter outlet portion 13 (or a foreign matter discharge portion). The first gas output portion 12 can be detachably connected to a first external device E1 (such as a turbo pump, a dry pump or a central scrubber such as a wet scrubber) in semiconductor equipment, but the present invention is not limited to the foregoing examples), and the first gas input portion 11, the first gas output portion 12 and the foreign matter outlet portion 13 are communicated with each other. For example, the particle separation component 1 can be a hollow tubular structure, and the main body 10 of the particle separation component 1 can be a hollow cavity. The first gas output portion 12 is provided on the top of the main body 10 of the particle separation component 1. The first gas output portion 12 can be a tubular structure and communicate with the interior of the main body 10 of the particle separation component 1. The foreign matter outlet portion 13 is provided on the bottom of the main body 10 of the particle separation component 1, and the foreign matter outlet portion 13 can be a tubular structure and communicate with the interior of the main body 10 of the particle separation component 1. The first gas input portion 11 is provided on the side of the main body 10 of the particle separation component 1 and adjacent to the top of the main body 10, and the first gas input portion 11 can be a tubular structure and communicate with the interior of the main body 10 of the particle separation component 1. More particularly, the first gas input portion 11 is provided in a tangential manner on the main body 10 of the particle separation component 1 (or the first gas input portion 11 can be extended along the tangent direction of the main body 10). Moreover, the main body 10 of the particle separation component 1, the first gas input portion 11 and the first gas output portion 12 can be in the shape of a straight tube, and the foreign matter outlet portion 13 can be in the shape of a cone. The diameter 11D of the first gas input portion 11 and the diameter 12D the first gas output portion 12 can be less than or equal to the diameter 10D of the main body 10 of the particle separation component 1. In one of the feasible or preferred embodiments, the main body 10 of the particle separation component 1, the first gas input portion 11, the first gas output portion 12 and the foreign matter outlet portion 13 can be an integrated structure.

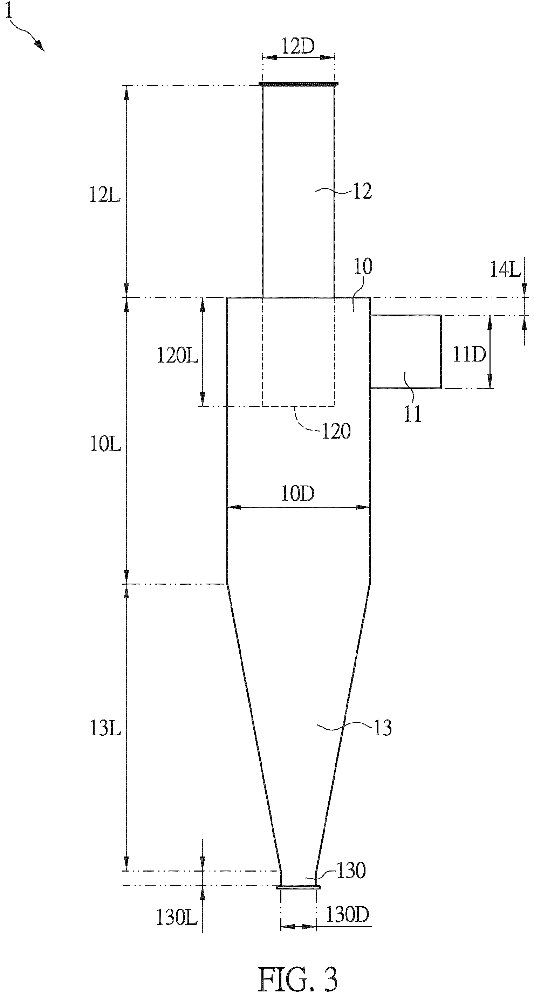

Furthermore, as shown in FIG. 3, the diameter 10D of the main body 10 of the particle separation component 1 can be defined as a predetermined value, which can be between 5 and 500, preferably 15 and 80, and the unit can be cm, but the present invention is not limited to the foregoing examples. The diameter 11D of the first gas input portion 11 and the diameter 12D of the first gas output portion 12 can be 0.01 to 1 times the predetermined value, preferably 0.5 times, that is to say, the diameter 11D and the diameter 12D can be between 9 cm and 220 cm, preferably 50 cm. The length 10L of the main body 10 and the length 13L of the foreign matter outlet portion 13 of the particle separation component 1 can be 0.5 to 4 times the predetermined value, preferably 2 times. The length 12L of the first gas output portion 12 can be 1 to 4.5 times the predetermined value, preferably 1.5 times. The outer edge of the first gas input portion 11 is separate from the top edge of the main body 10 of the particle separation component 1 by a predetermined distance 14L, and the predetermined distance 14L can be 0.1 to 0.5 times the predetermined value, preferably 0.125 times. It is worth mentioning that when the structure of the main body 10 and the foreign matter outlet portion 13 of the particle separation component 1 is designed to be elongated, smaller solid particles can be separated from the gas by the main body 10 and the foreign matter outlet portion 13 (such as separating fine suspended particles in gas with a particle size of 2.5 microns or less). When the structure of the main body 10 and the foreign matter outlet portion 13 of the particle separation component 1 is designed in a short and fat shape, larger solid particles can be separated from the gas by the main body 10 and the foreign matter outlet portion 13 (such as separating suspended particles in the gas with a particle size of more than 2.5 microns).

Furthermore, as shown in FIG. 3, one end of the foreign matter outlet portion 13 can be connected to the main body 10 of the particle separation component 1, and another end of the foreign matter outlet portion 13 can extend outward to form a protruding connection portion 130 that is connected to the particle collection component 3. More particularly, the protruding connection portion 130 can be a straight tubular structure. The diameter 130D of the protruding connecting portion 130 can be 0.1 to 0.5 times the predetermined value, preferably 0.25 times. The length 130L of the protruding connecting portion 130 can be 0.1 to 0.5 times the predetermined value, preferably 0.125 times. In addition, one end of the first gas output portion 12 can be connected to the main body 10 of the particle separation component 1, and another end of the first gas output portion 12 can extend toward the interior of the main body 10 of the particle separation component 1 to form an embedded guiding portion 120. The diameter of the embedded guiding portion 120 can be equal to the diameter 12D of the first gas output portion 12, and the length 120L of the embedded guiding portion 120 is 0.1 to 2.5 times the predetermined value, preferably 0.75 times.

Next, as shown in FIG. 1, FIG. 2, FIG. 5 and FIG. 6, the airflow output component 2 can have a main body 20, and one side of the main body 20 of the airflow output component 2 can extend outward to form an airflow inlet portion 21 (or a gas inlet portion). One end of the main body 10 of the airflow output component 2 can extend outward to form a second gas output portion 22, and another end of the main body 20 of the airflow output component 2 can extend outward to form a second gas input portion 23. The airflow inlet portion 21 can be detachably connected to an external gas source device G (such as a gas supply device in semiconductor equipment, which can provide general gas or special gas such as inert gas, but the present invention is not limited to the foregoing examples), and the second gas output portion 22 is connected to the first gas input portion 11, the second gas input portion 23 is detachably connected to a second external device E2 (such as a turbo pump, a dry pump or a central scrubber such as a wet scrubber) in semiconductor equipment, but the present invention is not limited to the foregoing examples), and the airflow inlet portion 21, the second gas output portion 22 and the second gas input portion 23 are communicated with each other. For example, the main body 20 of the airflow output component 2 can be in the shape of a trapezoid (such as a rounded trapezoid), a cone, or other similar geometric shapes. The main body 20 of the airflow output component 2 can have a cavity portion 200 and a guiding portion 201 (or a gas guiding portion). The cavity portion 200 can be a hollow structure, and one end of the cavity portion 200 can extend outward to form the second gas output portion 22. The cavity portion 200 may have a flat wall surface 200a and an arc wall surface 200b, in which the flat wall surface 200a is connected to the arc wall surface 200b, and the arc wall surface 200b can be connected with the inner wall surface of the second gas output portion 22. Another end of the cavity portion 200 can extend outward to form a first hook-shaped portion 200c, in which the outer edge of the first hook-shaped portion 200c can include a first arc a1, a second arc a2, and a third arc a3, in which the first arc a1 can be a fillet (or a rounded corner, or a round angle) between 1.5 cm and 2.5 cm, preferably 2 cm, but the present invention is not limited to the foregoing examples. The second arc a2 can be a fillet (or a rounded corner, or a round angle) between 2 and 3 cm, preferably 2.5 cm, but the present invention is not limited to the foregoing examples. The third arc a3 can be a fillet (or a rounded corner, or a round angle) between 5 cm and 7 cm, preferably 6.51 cm, but the present invention is not limited to the foregoing examples. The guiding portion 201 is surroundingly disposed on the side (i.e., the outer edge, or the outer surface) of the cavity portion 200. The outer edge of the guiding portion 201 can extend outward to form the airflow inlet portion 21. One end of the guiding portion 201 is connected to the cavity portion 200, another end of the guiding portion 201 extends in a rotational manner toward the cavity portion 200 to form a second hook-shaped portion 201a, and the second hook-shaped portion 201a extends outward to form the second gas input portion 23, in which a special flow channel 2010 can be defined between the guiding portion 201 and the cavity portion 200 (i.e., the interior of the guiding portion 201). The special flow channel 2010 can communicate with the airflow inlet portion 21 and the interior of the cavity portion 200, and the airflow inlet portion 21, the second gas output portion 22 and the second gas input portion 23 may have a tubular structure.

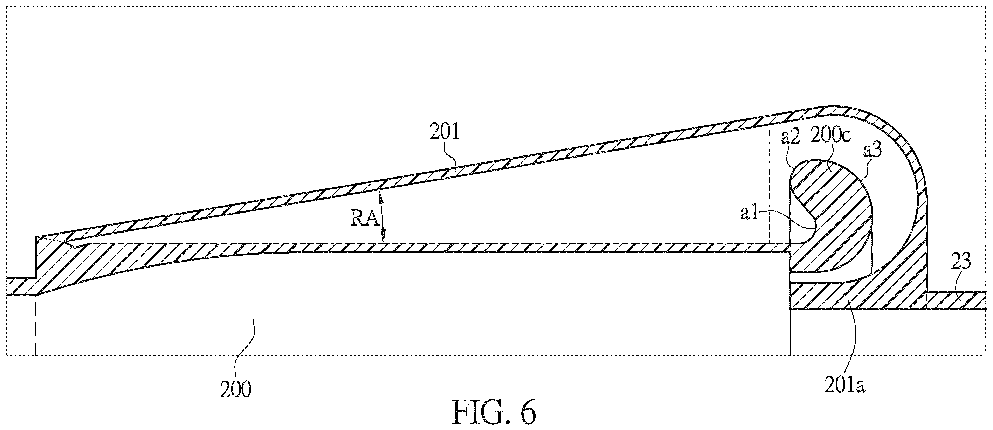

Furthermore, as shown in FIG. 5 and FIG. 6, the special flow channel 2010 can be divided into a first gas guiding area 2010a (or an airflow guiding area) and a second gas guiding area 2010b (or a gas exhausting area). The first gas guiding area 2010a is connected to the second gas guiding area 2010b, and the cross section of the first gas guiding area 2010a can be in a tapered shape, in which a predetermined included angle RA is defined between the inner wall surface of the guiding portion 201 and the outer wall surface of the cavity portion 200, and the predetermined included angle RA can range from 8 to 30 degrees (such as any positive integer ranging from 8 to 30 degrees), preferably 8 degrees, 16 degrees, 19 degrees, or 26.5 degrees, but the present invention is not limited to the foregoing examples. One end of the second gas guiding area 2010b communicates with the second gas guiding area 2010a, and another end of the second gas guiding area 2010a communicates with the interior of the cavity portion 200. The cross-section of the second gas guiding area 2010b can be C-shaped or hook-shaped.

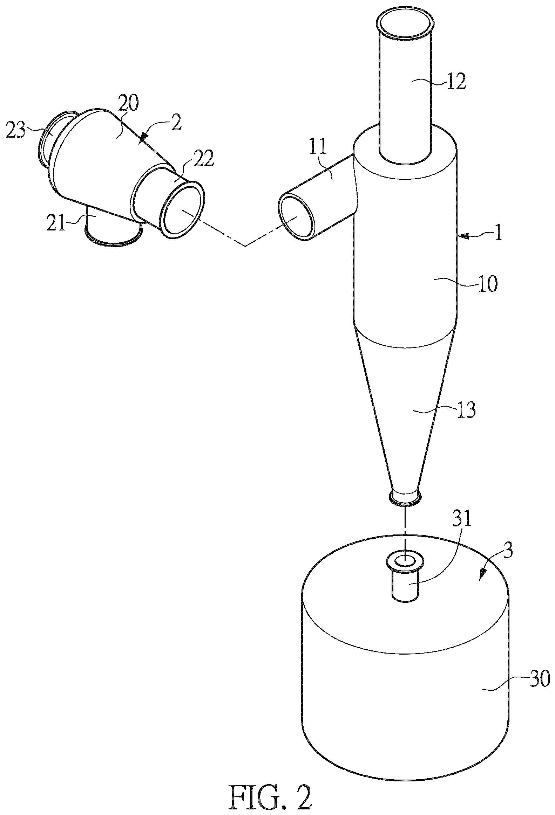

Next, as shown in FIG. 1 and FIG. 2, the particle collection component 3 is connected to the foreign matter outlet portion 13. For example, the particle collection component 3 can be a collection bucket or a collection tank. One end of the particle collection component 3 can extend outward to form the foreign matter inlet portion 31, and the foreign matter inlet portion 31 is connected to the foreign matter outlet portion 13, in which the diameter of the foreign matter inlet portion 31 is the same as the diameter 130D of the protruding connection portion 130.

Therefore, when the airflow inlet portion 21 receives driving airflows DA (or driving gas) provided by the external gas source device G, and the second gas input portion 23 receives harmful airflows HA (or harmful gas) provided by the second external device E2, at least one airflow output component 2 can drive the harmful airflows HA to flow toward the second gas output portion 22 by driving the driving airflows DA. When the first gas input portion 11 receives the harmful airflows HA provided by the second gas output portion 22, the first gas input portion 11 introduces the harmful airflows HA into the main body 10 of the at least one particle separation component 1 and drives the harmful airflows HA to flow in a vortex manner, so that at least one harmful substance HS in the harmful airflows HA can be separated from the harmful airflows HA to form purified airflows PA (or purified gas), and the at least one particle separation module 1 can deliver the purified airflows PA to the first external device E1 through the first gas output portion 12. The at least one particle separation component 1 collects at least one harmful substance HS that is separated from the harmful airflows HA through the foreign matter outlet portion 13, and the at least one harmful substance HS is transported to the at least one particle collection component 3. When the airflow inlet portion 21 receives the driving airflows DA, the guiding portion 201 introduces the driving airflows DA into the cavity portion 200 through the special flow channel 2010 and drives the harmful airflows HA to flow toward the second gas output portion 22, in which the second gas input portion 23 is configured to provide the harmful airflows HA to be introduced into the cavity portion 200 and mixed with the driving airflows DA to increase the flow intensity of the harmful airflows HA.

For example, as shown in FIG. 1 to FIG. 7, the dust collecting device Z of the present invention can be applied to semiconductor processing equipment and serve as an efficient dust capturing device in semiconductor processing equipment. Therefore, when the second external device E2 provides the harmful airflows HA generated by the semiconductor process to the dust collecting device Z, the dust collecting device Z can receive the driving airflows DA (such as the airflow of inert gas) that is provided by the external gas source device G through the airflow inlet portion 21 of the airflow output component 2, and can then be introduced into the special flow channel 2010. At this time, the airflow output component 2 can drive the driving airflows DA in the special flow channel 2010 in a vortex manner through the structural design of the special flow channel 2010. When the driving airflows DA flows into the interior of the cavity portion 200, the driving airflows DA will flow toward the cavity portion 200 and the second gas output portion 22 according to the structural design of the second gas guiding area 2010b. At the same time, the driving airflows DA can guide the harmful airflows HA that are introduced from the second gas input portion 23 and combine with the harmful airflows HA to form strong and stable airflows that flow toward the second gas output portion 22. Finally, the harmful airflows HA mixed with the driving airflows DA can be delivered to the particle separation component 1 through the second gas output portion 22.

Next, the dust collecting device Z can guide the harmful airflows HA delivered by the second gas output portion 22 into the interior of the main body 10 of the particle separation component 1 through the first gas input portion 11 of the particle separation component 1. Due to the arrangement and connection between the first gas input portion 11 and the main body 10 of the particle separation component 1, as well as the structural design of the main body 10 of the particle separation component 1, after the harmful airflows HA enters the body 10 of the particle separation component 1, the harmful airflows HA can flow inside the main body 10 of the particle separation component 1 in a vortex manner. During the flow of the harmful airflows HA, the harmful substances HS carried in the harmful airflows HA will fall toward the bottom of the main body 10 of the particle separation component 1 (such as falling toward the direction of the foreign matter outlet portion 13) and escape (or separate) from the harmful airflows HA. Then, the particle separation component 1 can collect the dropped harmful substances HS through the foreign matter outlet portion 13 and transport them to the interior of the main body 30 of the particle collection component 3 through the foreign matter inlet portion 31. After the harmful substances HS are separated from the harmful airflows HA, the harmful airflows HA forms the purified airflows PA, and moves and flows toward the first gas output portion 12.

Finally, the purified airflows PA is output to the first external device E1 through the first gas output portion 12.

Therefore, the dust collecting device Z of the present invention can use the above technical solution to utilize the structural design of the airflow output component 2 and cooperate with the airflows (active airflows) provided by the external gas source device G to increase the airflow of the harmful airflows HA and supply the harmful airflows HA to the particle separation component 1. Then the particle separation component 1 is used to capture the large and small dust in the harmful airflows HA to improve the removal efficiency of the harmful substances HS, thereby solving the problem of pipeline blockage in semiconductor processing equipment, and the solution provided by the present invention does not require additional electricity or water, and there will be no need to add additional heating tapes (such as a heating jacket system, or a pipe heating system) to the pipelines in the future.

### [Second Embodiment]

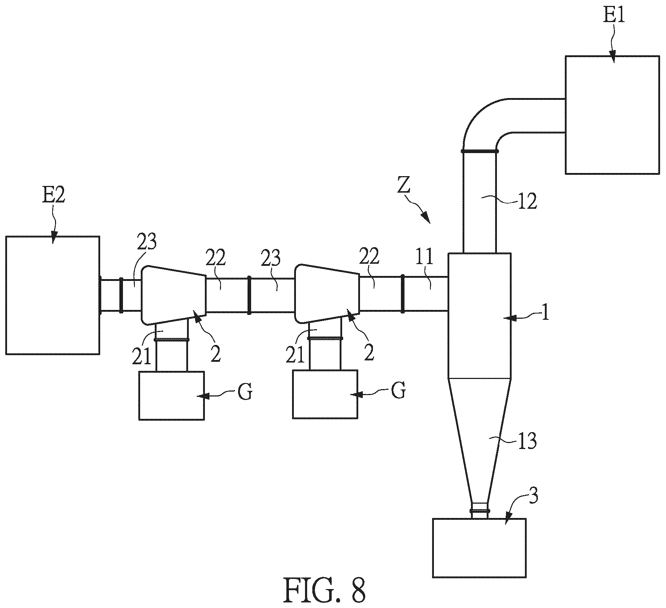

Please refer to FIG. 8, which is a schematic structural view of the dust collecting device according to a second embodiment of the present invention, and please refer to FIG. 1 to FIG. 7 as well. As shown in the figures, the dust collecting device Z of the second embodiment is roughly similar to the dust collecting device Z of the first embodiment. Therefore, the arrangement or operation of the same components will not be described again here. The difference between the second embodiment and the first embodiment is that in the second embodiment, the dust collecting device Z of the present invention can be provided with multiple airflow output components 2, in which there are two airflow output components 2 as an example, but the present invention is not limited to the foregoing examples.

For example, the dust collecting device Z of the present invention can be provided with multiple airflow output components 2, and each airflow output component 2 cooperates with an external gas source device G to greatly increase the airflow power (transmission power) of transmitting harmful airflows HA. Therefore, when the distance (or the pipeline) between the second external device E2 and the particle separation component 1 is too long, or the distance (or the pipeline) between the airflow output component 2 and the particle separation component 1 is too long, one or more airflow output components 2 can be provided between the second external device E2 and the particle separation component 1, or between the airflow output component 2 and the particle separation component 1, to prevent the airflow power of the harmful airflows HA from being too low and too slow, resulting in a reduction in the harmful substance removal efficiency of the particle separation component 1.

### [Third Embodiment]

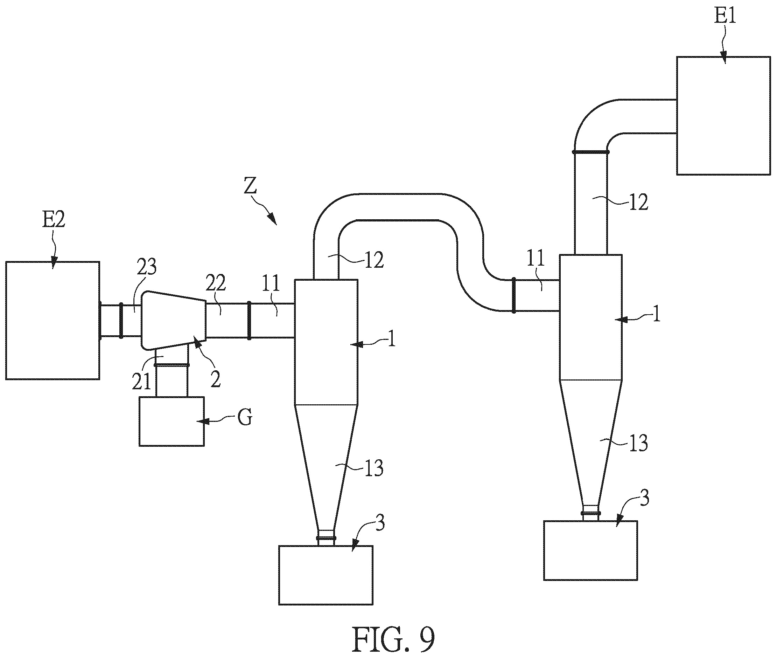

Please refer to FIG. 9, which is a schematic structural view of the dust collecting device according to a third embodiment of the present invention, and please refer to FIG. 1 to FIG. 8 together. As shown in the figures, the dust collecting device Z of the third embodiment is roughly similar to the dust collecting device Z of the above embodiments. Therefore, the arrangement or operation of the same components will not be described again here. The difference between the third embodiment and the above-mentioned embodiments is that in the third embodiment, the dust collecting device Z of the present invention can be provided with multiple particle separation components 1, in which there are two particle separation components 1 as an example, but the present invention is not limited to the foregoing examples.

For example, the dust collecting device Z of the present invention can be configured by placing one or more particle separation components 1 between the particle separation component 1 and the first external device E1, and the main body 10 of each particle separation component 1 has a different structural design (as described in the first embodiment), in order to improve the filtration efficiency of removing multiple harmful substances. Furthermore, when the harmful airflows HA contains harmful substances with particles of different sizes, after the airflow output component 2 transports the harmful airflows HA to the particle separation component 1, the dust collecting device Z of the present invention can use the first particle separation component 1 to filter out large particles of the harmful substances in the harmful airflows HA, and then the first particle separation component 1 can use the first gas output portion 12 to transport the harmful airflows HA (in which the large particles of the harmful substances are filtered out by the first particle separation component 1) to the second particle separation component 1. At this time, the dust collecting device Z of the present invention can use the second particle separation component 1 to filter out small particles of the harmful substances in the harmful airflows HA.

It is worth mentioning that the dust collecting device Z of the present invention is not limited to the above-mentioned embodiment. In actual implementation, the dust collecting device Z of the present invention can also use the first particle separation component 1 to filter out small particles of the harmful substances in the harmful airflows HA, and then use the second particle separation component 1 to filter out large particles of the harmful substances in the harmful airflows HA.

### [Fourth Embodiment]

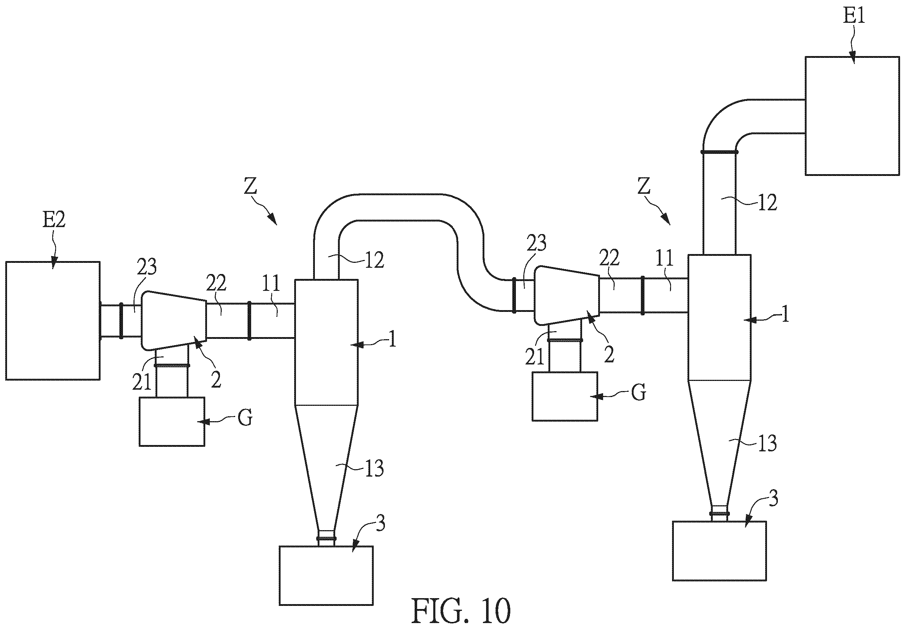

Please refer to FIG. 10, which is a schematic structural view of the dust collecting device according to a fourth embodiment of the present invention, and please refer to FIG. 1 to FIG. 9 as well. As shown in the figures, the dust collecting device Z of the fourth embodiment is roughly similar to the dust collecting device Z of the above embodiments. Therefore, the arrangement or operation of the same components will not be described again here. The difference between the fourth embodiment and the above-mentioned embodiments is that in the fourth embodiment, the present invention can be provided with multiple dust collecting devices Z, in which there are two dust collecting devices Z as an example, but the present invention is not limited to the foregoing examples.

For example, the present invention can improve the filtration efficiency of removing various harmful substances by using a plurality of dust collecting devices Z between the first external device E1 and the second external device E2, and can avoid reducing the airflow dynamics (transmission power) that transmit harmful airflows HA. Furthermore, the structural design of the main body 10 of the particle separation component 1 of each dust collecting device Z is different from each other (as described in the first embodiment). Therefore, the harmful airflows HA contains harmful substances with particles of different sizes, so that after the airflow output component 2 of the first dust collecting device Z delivers the harmful airflows HA to the particle separation component 1, the first particle separation component 1 can filter out the large particles of the harmful substances in the harmful airflows HA, and then the first particle separation component 1 can use the first gas output portion 12 to deliver the harmful airflows HA that filters out large particles of the harmful substances to the airflow output component 2 of the second dust collecting device Z. At this time, after the airflow output component 2 delivers the harmful airflows HA to the second particle separation component 1, the second particle separation component 1 can be used to filter out small particles of the harmful substances in the harmful airflows HA. In this embodiment, since the airflow output component 2 is also provided between the two particle separation components 1, the present invention can avoid the airflow power of the harmful airflows HA being too low and too slow, resulting in a reduction in the harmful substance removal efficiency of the particle separation component 1.

However, the aforementioned details are disclosed for exemplary purposes only in the above embodiments, and are not meant to limit the scope of the present invention.

### [Beneficial Effects of the Embodiments]

One of the beneficial effects of the present invention is that the dust collecting device Z provided by the present invention can improve the removal efficiency of the harmful substances and reduce production costs through the above technical solution.

Furthermore, the dust collecting device Z of the present invention can utilize the active airflows provided by external equipment through the above technical solution, so that the present invention does not require the use of additional energy-consuming gas-driven equipment (that is to say, no additional power supply is required at all), and does not consume water resources. Moreover, the dust collecting device Z of the present invention can be manufactured by a simple structural design, which can not only effectively improve the removal efficiency of the harmful substances, but also significantly reduce the cost of equipment maintenance. Moreover, it can also solve the problem of pipeline blockage in semiconductor manufacturing equipment, and the pipelines will not require heating tapes (such as a heating jacket system, or a pipe heating system) in the future.

In addition, the dust collecting device Z of the present invention can be provided with multiple airflow output components 2 to greatly increase the airflow power (transmission power) for transmitting harmful airflows HA, or the dust collecting device Z of the present invention can also be provided with multiple particle separation components 1 with different structural designs to improve the filtration efficiency of removing a variety of the harmful substances, or multiple dust collecting devices Z can also be provided to improve the filtration efficiency of removing a variety of the harmful substances and avoid reducing the airflow power (transmission power) of transmitting the harmful airflows HA.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A dust collecting device (Z), **characterized by** comprising:
at least one particle separation component (1) having a main body (10), one side of the main body (10) of the at least one particle separation component (1) extending outward to form a first gas input portion (11), one end of the main body (10) of the at least one particle separation component (1) extending outward to form a first gas output portion (12), another end of the main body (10) of the at least one particle separation component (1) extending outward to form a foreign matter outlet portion (13), the first gas output portion (12) being connected to a first external device (E1), and the first gas input portion (11), the first gas output portion (12) and the foreign matter outlet portion (13) communicating with each other;
at least one airflow output component (2) having a main body (10), one side of the main body (20) of the at least one airflow output component (2) extending outward to form an airflow inlet portion (21), one end of the main body (20) of the at least one airflow output component (2) extending outward to form a second gas output portion (22), another end of the main body (20) of the at least one airflow output component (2) extending outward to form a second gas input portion (23), the airflow inlet portion (21) being connected to an external gas source device (G), the second gas output portion (22) being connected to the first gas input portion (11), the second gas input portion (23) being connected to a second external device (E2), and the airflow inlet portion (21), the second gas output portion (22) and the second gas input portion (23) communicating with each other; and
at least one particle collection component (3) being connected to the foreign matter outlet portion (13).

2. The dust collecting device (Z) according to claim 1,
wherein, when the airflow inlet portion (21) receives driving airflows (DA) provided by the external gas source device (G), and the second gas input portion (23) receives harmful airflows (HA) provided by the second external device (E2), the at least one airflow output component (2) drives the harmful airflows (HA) toward the second gas output portion (22) through the driving airflows (DA);
wherein, when the first gas input portion (11) receives the harmful airflows (HA) provided by the second gas output portion (22), the first gas input portion (11) introduces the harmful airflows (HA) into the main body (10) of the at least one particle separation component (1) and drives the harmful airflows (HA) to flow in a vortex manner, so that at least one harmful substance (HS) in the harmful airflows (HA) escapes from the harmful airflows (HA) to form a purified airflows (PA), and the at least one particle separation component (1) delivers the purified airflows (PA) to the first external device (E1) through the first gas output portion (12);
wherein the at least one particle separation component (1) collects the at least one harmful substance (HS) that is separated from the harmful airflows (HA) through the foreign matter outlet portion (13) and delivers the at least one harmful substance (HS) to the at least one particle collection component (3).

3. The dust collecting device (Z) according to claim 2,
wherein the main body (20) of the at least one airflow output component (2) has a cavity portion (200) and a guiding portion (201), one end of the cavity portion (200) extends outward to form the second gas output portion (22), another end of the cavity portion (200) extends outward to form a first hook-shaped portion (200c), the guiding portion (201) surrounds one side of the cavity portion (200), an outer edge of the guiding portion (201) extends outward to form the airflow inlet portion (21), one end of the guiding portion (201) is connected to the cavity portion (200), another end of the guiding portion (201) extends toward the cavity portion (200) in a rotational manner to form a second hook-shaped portion (201a), and the second hook-shaped portion (201a) extends outward to form the second gas input portion (23);
wherein a special flow channel (2010) is defined between the guiding portion (201) and the cavity portion (200), and the special flow channel (2010) is in communication with the airflow inlet portion (21) and the cavity portion (200).

4. The dust collecting device (Z) according to claim 3,
wherein, when the airflow inlet portion (21) receives the driving airflows (DA), the guiding portion (201) introduces the driving airflows (DA) into the cavity portion (200) through the special flow channel (2010) and drives the harmful airflows (HA) toward the second gas output portion (22);
wherein the second gas input portion (23) is configured to provide the harmful airflows (HA) to be introduced into the cavity portion (200) and mixed with the driving airflows (DA) to increase the flow intensity of the harmful airflows (HA).

5. The dust collecting device (Z) according to claim 3 or 4, wherein the special flow channel (2010) is divided into a first gas guiding area (2010a) and a second gas guiding area (2010b), the first gas guiding area (2010a) is connected to the second gas guiding area (2010b), the first gas guiding area (2010a) has a tapered cross-section, and the second gas guiding area (2010b) has a C-shaped or hook-shaped cross-section.

6. The dust collecting device (Z) according to any one of the preceding claims, wherein the main body (10) of the at least one particle separation component (1), the first gas input portion (11) and the first gas output portion (12) are in the shape of a straight tube, and the foreign matter outlet portion (13) is in the shape of a cone, a diameter (11D) of the first gas input portion (11) and a diameter (12D) of the first gas output portion (12) are smaller than or equal to a diameter (10D) of the main body (10) of the at least one particle separation component (1).

7. The dust collecting device (Z) according to claim 6, wherein the diameter (10D) of the main body (10) of the at least one particle separation component (1) is defined as a predetermined value, the diameter (11D) of the first gas input portion (11) and the diameter (12D) of the first gas output portion (12) is 0.01 to 1 times the predetermined value, a length (10L) of the main body (10) of the at least one particle separation component (1) and a length (13L) of the foreign matter outlet portion (13) is 0.5 to 4 times the predetermined value, and a length (12L) of the first gas output portion (12) is 1 to 4.5 times the predetermined value.

8. The dust collecting device (Z) according to claim 7, wherein one end of the foreign matter outlet portion (13) is connected to the main body (10) of the at least one particle separation component (1), another end of the foreign matter outlet portion (13) extends outward to form a protruding connection portion (130) that is connected to the at least one particle collection component (3), a diameter (130D) of the protruding connection portion (130) is 0.1 to 0.5 times the predetermined value, and a length (130L) of the protruding connection portion (130) is 0.1 to 0.5 times the predetermined value.

9. The dust collecting device (Z) according to claim 7 or 8, wherein one end of the first gas output portion (12) is connected to the main body (10) of the at least one particle separation component (1), another end of the first gas output portion (12) extends toward the main body (10) of the at least one particle separation component (1) to form an embedded guiding portion (120), a diameter of the embedded guiding portion (120) is equal to the diameter (12D) of the first gas output portion (12), and a length (200) of the embedded guiding portion (120) is 0.1 to 2.5 times the predetermined value.

10. The dust collecting device (Z) according to any one of the preceding claims, wherein one end of the at least one particle collection component (3) extends outward to form a foreign matter inlet portion (31), and the foreign matter inlet portion (31) is connected to the foreign matter outlet portion (13).
